# EUROPEAN PATENT SPECIFICATION

(11) **EP 2 773 797 B1**
(45) Date of publication and mention of the grant of the patent: **05.08.2015**
(21) Application number: 12779085.5
(22) Date of filing: 02.11.2012
(51) Int. Cl.: C30B 11/00, C30B 11/14, C30B 29/06

(54) **CRUCIBLE AND METHOD FOR THE PRODUCTION OF A (NEAR) MONOCRYSTALLINE SEMICONDUCTOR INGOT**
TIEGEL UND VERFAHREN ZUR HERSTELLUNG EINES (FAST) MONOKRISTALLINEN HALBLEITERBLOCKS
CREUSET ET PROCÉDÉ DE PRODUCTION D'UN LINGOT SEMI-CONDUCTEUR (PRESQUE) MONOCRISTALLIN

(30) Priority: 04.11.2011 EP 11187970
(43) Date of publication of application: 10.09.2014
(73) Proprietor: Vesuvius France S.A., 59750 Feignies (FR)
(72) Inventor: RANCOULE, Gilbert, F-59700 Marcq-en-Baroeul (FR); MARTIN, Christian, F-59750 Feignies (FR)
(74) Representative: Debled, Thierry
(86) International application number: PCT/EP2012/071711
(87) International publication number: WO 2013/064626

(56) References cited:
- EP-A1- 1 739 209
- EP-A2- 0 949 358
- WO-A1-2009/014961
- WO-A1-2010/088046
- FR-A1- 2 509 638
- US-A1- 2004 211 496

## Description

### FIELD OF THE INVENTION

The present invention generally relates to the production of semiconductor crystals, such as silicon, for use in photovoltaic applications. In particular, it concerns a specific crucible suitable for the production of monocrystalline or near-monocrystalline semiconductor ingots for the production of semiconductor wafers, having a particularly advantageous cost to quality ratio.

### BACKGROUND OF THE INVENTION

Semiconductor wafers, such as silicon, are widely used in photovoltaic applications to convert photonic energy into electrical energy. Ideally, monocrystalline semiconductors, like monocrystalline silicon (MCS) are used, yielding an electrical conversion ratio of the order of 18 19%. The production of semiconductor monocrystals is, however, rather slow and expensive, typically using Czochralski drawing process. The Czochralski drawing process described e.g., in EP1897976, US2011/214603, and WO2011/083529, consists of drawing and crystallizing an ingot out of a pool of molten semiconductor. The drawing conditions must be strictly controlled to minimize the formation of defects and, in particular, the drawing rate of the ingot must be very low which increases the production cost beyond what the photovoltaic industry is ready to pay for. Semiconductor wafers produced by the Czochralski drawing process are therefore generally used in electronic applications and seldom in photovoltaic applications.

As described e.g., in US2007/0227189, FR-A1-2509638 or EP-A2-949358, a much cheaper type of semiconductor wafer is polycrystalline, such as polycrystalline silicon (PCS), generally produced using a Bridgman growth technique, wherein a pool of molten semiconductor material contained in a crucible is cooled in a controlled manner to solidify the material from the bottom of the crucible and moving up the crystal-liquid front towards the top of the crucible. To carry out such process a crucible is positioned in an oven and filled with a semiconductor feedstock. The oven is activated to melt the whole mass of feedstock. Heat is then extracted through the bottom floor with a heat sink positioned below the crucible; generally the heat sink comprises a gas flowing in pipes. By varying the gas flow rate, it is possible to control the heat extraction rate from the feedstock. As the temperature within the feedstock layer in contact with the floor reaches the crystallization temperature, crystals will start growing from the bottom floor and extend upwards, as the crystallization front proceeds. A careful control of the heat flow and adhesion of the ingot to the crucible side walls during the Bridgman process is required to prevent generation of cracks in the ingot. For example, it is proposed in FR2509638 to provide the crucible with a top layer consisting of a flexible fabric of ceramic fibres having a low heat capacity, and able to receive directly a batch of molten silicon, such that the top layer can be heated very rapidly to the silicon temperature upon contact with the latter. In EP949358, a release top layer of sintered fused silica powder of size not more than 100 µm is provided on top of a sintered coarse fused silica layer of particle size of 500 to 1500 µm, which readily releases from the latter upon shrinking of the crystallized ingot. Batches of up to 500 kg can be produced using the Bridgman technique compared with about 100 kg batches with the Czochralski drawing process. When the cost of polycrystalline semiconductor ingots produced by the Bridgman technique is about a third of the one of monocrystalline ingots produced with the Czochralski technique, the conversion ratios of about 14 16% obtained with polycrystalline wafers are quite low compared with the ones obtained with monocrystalline wafers.

Recent studies have shown that monocrystalline or near monocrystalline semiconductor ingots could be produced using the Bridgman technique by tiling the floor of a crucible with monocrystalline seeds, which are a few millimetre to centimetre thick slabs of monocrystalline semiconductor material, obtained e.g., by the Czochralski technique. Such results are presented for example in FR2175594, WO2010/005705, US2011/0146566, and US2010/0003183. The top surface of the seeds, in contact with the feedstock, should melt with the latter. Heat must be extracted from the bottom of the crucible before the bottom surface of the seeds starts melting, so that a monocrystalline ingot may grow from the partially melted seeds, taking care to maintain a stable solidification front as crystallization proceeds. The temperature profile within the crucible must therefore be controlled very accurately.

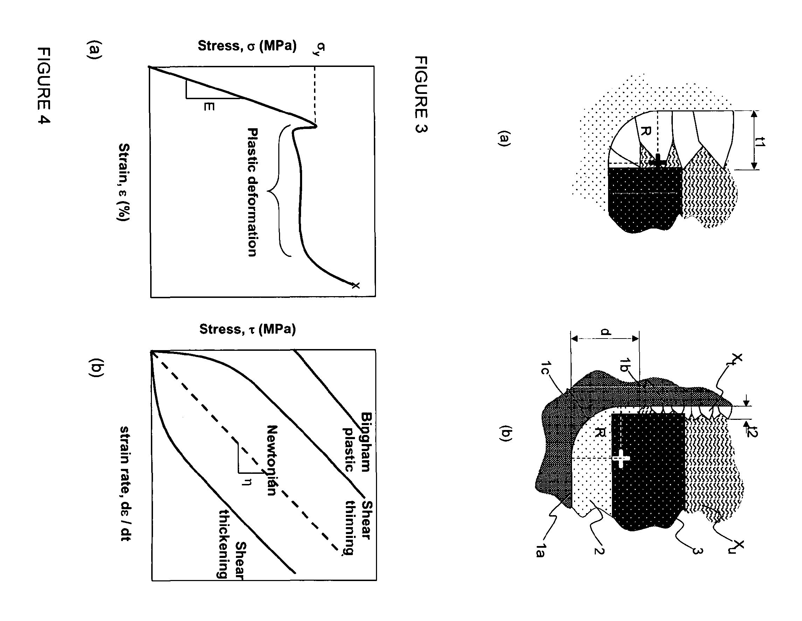

A first limitation of the (near-) monocrystalline growth of a semiconductor ingot using a Bridgman process is that, besides the unidirectional crystals, Xᵤ, growing from the floor, transverse crystals, Xₜ, grow from the lateral walls of the crucible in a direction transverse to the general growth direction of the monocrystal as illustrated in Figure 3(a). The length, t₁, of these transverse crystals may reach several cm, which may create defects in the adjacent unidirectional crystal lattice and must be trimmed off the ingot and melted again as they are not fit to be used for photovoltaic applications, to the detriment of the efficacy of the process. A second limitation of such process is that the temperature profile required for carrying out the crystallization relies on the temperature control of relatively large furnaces. In spite of substantial progress made on the temperature control of such ovens, they still lack the accuracy required for such delicate process.

The present invention proposes a solution for producing a (near) monocrystalline semiconductor ingot by a Bridgman process with transverse crystals growing from the lateral walls of the crucible of thickness substantially lower than henceforth achieved. The present invention also allows compensating for unwanted, albeit unavoidable, temperature gradients within a given furnace, such that a stable, convex crystallization front proceeds anyway. These and other advantages of the present invention are presented in continuation.

### SUMMARY OF THE INVENTION

The present invention is defined by the attached independent claims. The dependent claims define preferred embodiments. In particular, the present invention concerns a crucible for the production of crystalline semiconducting material ingots, such as silicon, said crucible comprising peripheral side walls and a floor at least a portion of said floor being coated with a top layer, characterized in that, said top layer has a thickness, δ, of at least 500 µm and in that, at a deformation temperature below 1400°C said top layer is plastically or viscously deformable.

The top layer may comprise one or more of silicon nitride (Si₃N₄), sialon, silicon oxynitride, siloxane, silazane, fused quartz or fused silica, synthetic silica, alumina, natural or synthetic CaO-, SiO₂-, Al₂O₃-, MgO-, ZrO₂-based ceramic materials in the form of:
- a low density layer, like a foam, of density preferably comprised between 0.3 and 1.6 g/cm³, more preferably between 0.8 and 1.3 g/cm³, or
- particulate, such as non-woven fibres, hollow shells, nanoparticles, meso-spherous particles.

Each of the foregoing materials preferably have an Fe content of less than 20 ppm , more preferably less than 5 ppm, most preferably less than 1 ppm. The density of the top layer is preferably at least 20% lower than the density of the inner surfaces of the other walls defining the inner volume of the crucible.

The top layer may comprise one layer only or, alternatively, it may comprise two, or more layers of different materials. If there are several layers, it is preferred that the uppermost layer is made of, or comprises silicon nitride (Si₃N₄).

The top layer preferably has a thickness greater than 0.6 mm, preferably greater than 0.8 mm, more preferably greater than 1.0 mm, most preferably greater than 2.0 mm and has a thickness of preferably not more than 20.0 mm, more preferably, not more than 10.0 mm, most preferably, not more than 5.0 mm.

If the floor of the crucible joins the side walls thereof forming an edge having a radius, R, then the thickness, δ, of the top layer is preferably larger than the radius, R, so that the floor may be tiled with seeds forming a flat covering up to the very edges of the crucible.

The deformable top layer has the advantage of offering an optimal base for laying the crystallization seeds. At least one crystallization seed can thus be impressed in the top layer. Of course, it is preferred that the whole floor be covered with seeds, and at least two crystallization seeds must then be impressed side by side in the top layer, with their top surfaces being substantially co-planar. It is nearly impossible to ensure a homogeneous temperature throughout the whole volume of an oven of the size required for carrying out a Bridgman process industrially. For ensuring that the heat flow through the seeds and bottom floor of the crucible be homogeneous in spite of the local temperature variations characterizing a given oven, it is possible to locally use thinner or thicker seed plates to accelerate or slow down the heat flow between the top surface of the seeds and the heat sink.

The seeds are preferably monocrystalline. It is possible, however, to use polycrystalline seeds, having a particular grain orientation or size to form a polycrystalline ingot. The present crucible is particularly suitable for growing silicon ingots.

The present invention also concerns a process for producing an oriented crystalline semiconductor material ingot, preferably a mono- or near mono-crystalline ingot, comprising the following steps:
- providing a crucible as discussed supra,
- laying at least one crystallization seed onto the top layer;
- bringing the temperature of the top layer to the deformation temperature thereof;
- applying a pressure onto the at least one crystallization seed to impress it into the top layer such that it sinks at least partially into the deformable top layer;
- filling the crucible with a load of semiconductor material feedstock;
- raising the temperature in the crucible to melt completely the feedstock and to melt the top surface of the at least one crystallization seed;
- extracting heat through the floor of the crucible to prevent the bottom surface of the at least one crystallization seed from melting and to initiate the oriented crystallization of the feedstock.

The pressure to impress the at least one crystallization seed may be applied by the own weight of the feedstock as temperature in the crucible is rising above the deformation temperature. It is, however, preferred that the pressure be applied onto the at least one seed in a controlled manner, preferably with an appropriate tool, ensuring that the final position of the seed be reproducible. In particular, the pressure can be applied to the at least one crystallization seed by controlling the length of a rigid vertical stem from a first end thereof contacting one crystallization seed to a fixed point, such as the upper edge of the crucible, or any fixed point inside or outside the crucible.

In practice, it is particularly preferred that the top layer covers the whole area of the crucible floor, and that two or more crystallization seeds be tiled side by side to cover substantially the whole area of the top layer. The two or more crystallization seeds should be impressed onto the top layer such that their top layers be substantially coplanar.

As discussed above, in spite of the extensive studies for developing ovens capable of controlling the heat flow quite accurately, the accuracy thus achieved is generally insufficient to control the heat flow such as to obtain an optimal crystallization front shape and advancing rate. To solve this problem, the process of the present invention, may further comprise the following steps:
(a) for a given furnace, the temperature distribution over the area of the top surface of the at least two crystallization seeds is characterized during the heat extraction step;
(b) a mapping of hot and cold spots is established over the whole top surface area of the seeds as a function of the position of each of the at least two crystallization seeds;
(c) the thickness of each of the at least two crystallization seeds is determined such as to allow the homogenization of the temperature distribution over the whole top surface area of the seeds during the heat extraction step in said furnace;
(d) tile the crucible floor with the at least two crystallization seeds of thus determined thicknesses in their corresponding positions;
(e) load the crucible with a feedstock and carry out the necessary steps for melting and crystallizing the feedstock to form an oriented crystalline semiconductor material ingot.

In a preferred embodiment of the process of the present invention, the one or more crystallization seeds are silicon, preferably monocrystalline silicon, and the feedstock is composed of silicon and doping materials used in the production silicon ingots. The thus obtained ingots can then be cut into wafers, which can then be further treated to produce solar cells.

A crucible as discussed above may be manufactured by a process comprising the following steps:
(a) manufacturing a crucible made of a silicon oxide based refractory material and comprising a floor and side walls;
(b) optionally applying one or more coatings to the inner surfaces of the floor and/or side walls of said crucible;
(c) applying to the floor by spraying, rolling, casting, brushing, or any combination thereof, a top layer of thickness, δ, of at least 500 µm, said top layer being plastically or viscously deformable at a deformation temperature below 1400 °C.

### BRIEF DESCRIPTION OF THE FIGURES.

Various embodiments of the present invention are illustrated in the attached Figures.
Figure 1: shows schematically four steps of a process according to the present invention for the crystallization of a semiconductor ingot.
Figure 2: shows schematically how to correct for temperature gradients within a given oven, such as to obtain a desired temperature profile within the crucible,
Figure 3: schematically shows the crystalline structure, Xₜ, growing transverse to a unidirectional ingot from the side walls of a crucible (a) of the prior art, and (b) according to the present invention.
Figure 4: schematically shows (a) a stress vs. strain curve typical of a plastically deformable material, and (b) stress vs. strain rate curves typical of viscously deformable materials.

### DETAILED DESCRIPTION OF THE INVENTION

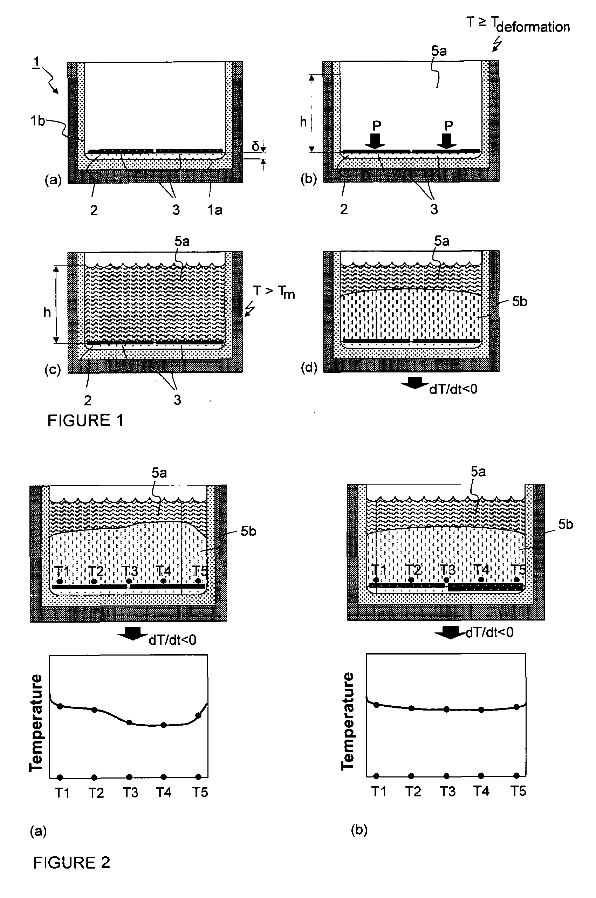

As can be seen in Figure 1 (a), a crucible (1) according to the present invention is quite similar to crucibles used in the art for growing (near-) monocrystalline ingots of e.g., silicon, using a Bridgman technique. It comprises a bottom floor (1 a), and side walls (1 b) made of a silicon oxide based refractory material, such as quartz. It may have a circular base, but it generally has a square or rectangular base. The floor and sidewalls may comprise a coating as generally used in the art of a few micrometer thick layer of, e.g., silicon nitride. The floor (1 a) of the crucible may be tiled with crystallization seeds (3) preferably covering substantially the whole area of said floor. A crucible according to the present invention distinguishes itself from crucibles of the prior art in that the floor (1 a) comprises a top layer (2) having a thickness, δ, of at least 500 µm which, as illustrated in Figure 1(b), is plastically or viscously deformable at or above a deformation temperature, T_{deformation}, such that the crystallization seeds (3) may be impressed, at least partially sinking into the top layer (2) upon application of a pressure, P, there upon. The deformation temperature shall be lower than 1400 °C. The lower the deformation temperature, the easier is the handling and positioning of the crystallization seeds, and it may perfectly well be room temperature.

As well known by the persons skilled in the art, a plastically deformable material is a material undergoing irreversible deformation upon application of a load. This is to be opposed to an elastic deformation which is reversible. Usually, plastic deformation occurs at loads higher than the so called yield strength, σ_{y}, below which the deformation is generally elastic. An example of stress (σ) vs. strain (ε) curve of a plastically deformable material is illustrated schematically in Figure 4(a).

Viscous deformation, on the other hand, is the characterized by the relationship between deformation and strain rate which is proportional to viscosity. As illustrated in Figure 4(b), the viscosity, η, may vary during deformation. When viscosity is independent of stress and strain rate, like water, the fluid is said to be Newtonian. If the viscosity decreases with increasing stress and strain rate, the material is said to be shear thinning or in some cases thixotropic, like ketchup. On the contrary, when viscosity increases, the material is said to be shear thickening. A Bingham plastic is a material that behaves as a solid at low stresses but flows as a viscous fluid at high stresses. A viscously deformable top layer is herein meant to refer to a top coating having a viscosity of at least 500 mPa.s, preferably at least 1 Pa.s, more preferably, at least 5 Pa.s, more preferably at least 20 Pa.s, wherein the viscosity is measured with parallel plates rotating at 1 Hz at a temperature between the deformation temperature and 1400°C.

The top layer (2) may typically comprise one or more of silicon nitride (Si₃N₄), fused quartz or fused silica, synthetic silica, silica gel, alumina, natural or synthetic CaO-, SiO₂-, Al₂O₃-, MgO-, ZrO₂-based ceramic materials in the form of:
- a low density layer, like a foam, of density preferably comprised between 0.3 and 1.6 g/cm³, more preferably between 0.8 and 1.3 g/cm³, and being most preferably of density at least 20% lower than the density of inner surfaces of the other walls defining the inner volume of the crucible. Or
- particulate, such as non-woven fibres, hollow shells, nanoparticles.

The particulate material preferably comprises a binder to stabilize the coating. The binder should preferably be deformable at low temperature, or be present in a low enough amount such that the top layer may still yield as a crystallization seed is impressed thereupon. The binder may itself be a foam or display a plastic, viscous or viscoelastic behaviour to yield upon application of a pressure onto a crystallization seed. For example, the binder may be a silica gel or colloidal silica. The material(s) of the top layer (2) should have an Fe content of less than 20 ppm , more preferably less than 5 ppm, most preferably less than 1 ppm, as iron is detrimental to the crystallization of most semiconductors, in particular silicon. The top layer (2) may comprise several layers, the combination of layers forming a deformable top layer. For example, it may have a base layer of silicon particles, or porous silica and a top layer of silicon nitride (Si₃N₄). For its advantageous properties in combination with silicon, it is preferred that the uppermost layer comprise silicon nitride (Si₃N₄).

The top layer (2) must have a thickness of at least 500 µm. It can of course have a greater thickness, such as a thickness greater than 0.6 mm, preferably greater than 0.8 mm, more preferably greater than 1.0 mm, most preferably greater than 2.0 mm. For economical reasons as well as for heat extraction efficacy, however, it is preferred that the top layer (2) have a thickness of not more than 20.0 mm, more preferably, not more than 10.0 mm, most preferably, not more than 5.0 mm.

A crystallization seed (3) is a plate of thickness of about 5 to 25 mm, preferably, 8 to 15 mm, more preferably 10 to 12 mm. A thinner seed is advantageous in terms of cost, in particular if it is monocrystalline, and in terms of heat extraction rate. It is, however, more problematic to control that the upper surface of the seed be molten, whilst not the bottom, as the thickness of the seed decreases. The optimal thickness of the crystallization seeds for a given application therefore depends on the skill of the operator, and on the equipment used.

By the process used to manufacture crucibles for growing semiconductor ingots and to prevent the formation of high stress concentrations in the refractory material -for example quartz, the floor (1 a) normally joins the side walls (1 b) of the crucible forming a radius, R, as illustrated with reference number (1 c) in Figure 3. The radius, R, of the inner edges of a crucible is generally of the order of 5 to 20 mm, particularly 8 to 15 mm. The crystallization seeds must lie flat on the bottom floor (1 a), and can therefore cover the floor only where it is flat. Consequently, the perimeter formed by the tiled seeds must be separated from the side walls (1 b) by a distance at least equal to R (cf. Figure 3(a)). As heat is being evacuated through the bottom floor, crystals, Xᵤ, will grow upwards starting from the molten surface of the seeds (3), but crystals, Xₜ, will also grow sideward starting from the side walls (1 b). The advancing thermal front is controlled such as to have a flat or, preferably convex shape (cf. Figure 1 (d)) which promotes the growth of the vertical crystals, Xᵤ, to the detriment of the lateral crystals, Xₜ, but the latter may still grow over a distance, t₁, of a few centimetres, It follows that each lateral side of an ingot must be trimmed over a few centimetres before cutting wafers therefrom, which represents a serious limitation to the efficacy of the process.

If the top layer (2) has a thickness, δ, greater than the radius, R, of the curved inner edges (1 c) of the crucible (1), the seeds (3) may cover substantially the whole area of the floor (1 a), quite close to, if not in contact with the side walls (1 b) as illustrated in Figure 3(b). In these conditions it has been observed that the size, t₂, of the lateral crystals, Xₜ, was substantially smaller than the crystals size, t₁, obtained with prior art crucibles (compare Figures 3(a)&(b)). The size reduction of the lateral crystals, Xₜ, represents a substantial economy over the prior art process, because the thickness an ingot must be trimmed is controlled by the largest of the lateral crystals, Xₜ and the amount of high value scrape material is reduced accordingly. It is clear that the scrape material can be re-used as feedstock and melted again, but this process is quite energy consuming.

As can be seen in Figure 3(b), the crystallization seeds (3) are impressed into the top layer (2), i.e., it is partially embedded in the top layer (2). This has a first advantage in that the planarity of the top surfaces of the tiled crystallization seeds (3) can be ensured easily by controlling the pressure applied thereon to impress the seeds into the top layer. The smoothness of the floor (1 a) of the crucible is therefore not so critical any more. In prior art crucibles, the seeds are laid directly onto the floor or on top of a thin coating, and any defect on the floor affect the planarity of the seeds. The floor must therefore be machined and polished quite finely, which is a labour and cost intensive operation. This operation is not necessary anymore with a crucible of the present invention, which reduces substantially the cost thereof. Another advantage of the top layer of the present invention, is that, contrary to the imperfect contact between a seed and the refractory floor of a crucible, the contact between the seed and top layer is quite intimate. The thermal conductivity is enhanced accordingly and the heat flow rate obtained therewith can even be higher than the one obtained with a poorly polished floor, in spite of the additional thickness of the top layer (2).

As illustrated in Figure 2(a) most Bridgman type apparatuses, comprising an oven and a heat sink, cannot provide temperature profile homogeneity as accurate as required by the tight crystallization conditions of the process. In Figure 2, the temperature at the surface of tiled seeds is measured at five points, T1 T5, and schematically represented in the temperature-position plot underneath. Because a given apparatus will have specific cold and hot spots, the temperature profile at the top of the seeds is deformed and does not provide for optimal crystallization conditions. The crystallization front separating (near) unidirectionally crystallized material (5b) from the molten material (5a) is biased accordingly, creating defects in the crystal lattice.

By using crystallization seeds (3) of varying thicknesses at places of differing temperatures, it is possible to correct the temperature profile within the crucible and the shape of the crystallization front, in spite of the oven/heat sink thermal inhomogeneity. As illustrated in Figure 2(b), if a thicker seed (3) is used at locations T4 and T5, where the oven/heat sink revealed a cold spot (cf. temperature-position plot of Figure 2(a) at positions T4&T5), the cooling rate can be locally reduced at locations T4&T5 and the temperature measured at the top surface of the seed at said locations can be levelled with the temperatures measured at locations T1 and T2. Of course, instead of using a thicker seed to slow down the heat flow across the seeds and crucible floor, it is also possible to use thinner seeds to increase the heat flow to compensate for local hot spots. By levelling the temperature profile within the crucible, the crystallization front is levelled too, so that a crystal with substantially less lattice defects can be formed. The deformable top layer (2) permits to tile the floor (1 b) with crystallization seeds of different thicknesses and still forming a planar surface, by impressing the thicker seeds deeper into the top layer than the thinner seeds. A planar top surface of the tiled seeds is preferred. It is, however, not always possible, if the difference in thicknesses between two seeds is too large, to compensate the thickness differences by varying the impressing depth. A difference of levels of the top surfaces of the seeds is acceptable as long as they are parallel to each other. The correction of the temperature front can still be achieved in these conditions. It is, however, preferred that the top surfaces of the seeds be coplanar, in particular if the crystallization seeds are monocrystalline.

A (near-) monocrystalline ingot can therefore advantageously be produced with a process according to the present invention comprising, as schematically illustrated in Figure 1, the following steps:
(a) providing a crucible as discussed above, comprising on its floor (1 a) a top layer (2) of thickness, δ, of at least 500 µm and being plastically or viscously deformable at a deformation temperature below 1400°C; it is preferred that the deformation temperature be lower than 200°C, more preferably lower than 100°C, more preferably around room temperature;
(b) laying at least one crystallization seed (3) onto the top layer (2) (cf. Figure 1 (a)); it is much preferred that substantially the whole area of the crucible floor (1 a) be tiled by at least two crystallization seeds positioned side by side, with their top surfaces preferably substantially parallel to each other, and more preferably coplanar;
(c) bringing the temperature of the top layer to the deformation temperature thereof;
(d) applying a pressure onto the at least one crystallization seed to impress it into the top layer (2) such that it sinks at least partially into the deformable top layer (cf. Figure 1 (b));
(e) filling the crucible with a load of semiconductor material feedstock;
(f) controlling the temperature in the crucible to ensure that the feedstock is completely molten (5a) and the top surface only of the at least one crystallization seed is molten too (cf. Figure 1 (c)); furnaces specifically designed for a Bridgman process and provided with a heat sink and accurate temperature control systems are available on the market;
(g) extracting heat through the floor of the crucible to prevent the bottom surface of the at least one crystallization seed from melting and to initiate the oriented crystallization (5b) of the feedstock (cf. Figure 1(d)).

The pressure in step (d) can be applied by simply putting weights on top of each crystallization seed (3). This rather simple solution, however, does not permit to ensure that the top surfaces of all the seeds are parallel to each other, let alone coplanar. Coplanarity can be somehow improved -though not ensured- by first laying a plate on top of the whole surface tiled by the crystallization seeds, and apply thereupon a pressure, e.g., by weights. This solution, however, cannot be applied in case seeds of different thicknesses lie on a top layer (2) of thickness insufficient for absorbing the differences in thicknesses of the seeds. In a preferred embodiment, a levelling device is used to impress the crystallization seeds into the top layer. The levelling device can be fixed to the upper edges of the crucible, or can be mounted on a frame comprising a receiving portion for accommodating a crucible. The levelling device preferably comprises as many stems as there are crystallization seeds, and are mounted such as to contact the centre of each seed. The contacting end of each stem is preferably provided with a planar plate extending normal to the stem and of smaller or same dimensions as the seeds. The stems with their contact plates can be moved with accuracy along the vertical direction with e.g., a threaded system. Pressure can be applied to each seed by controlling the length of each stem (position control) or by controlling the force applied by each stem, such as with a helicoidal spring or other resilient means.

To account for any temperature inhomogeneity in a given furnace + heat sink system used to control the temperature within a crucible, the following steps can be carried out:
for a given furnace, the temperature distribution over the area of the top surface of the at least two crystallization seeds is characterized during the heat extraction step; this can be done either by placing a number of thermocouples at different spots of the top surface of the seeds (cf. Figure 2(a), bottom plot), or alternatively with an infrared camera;
   - a mapping of hot and cold spots is established over the whole top surface area of the seeds as a function of the position of each of the at least two crystallization seeds; the mapping may include various stages of the cooling step, as the heat sink is activated at different rates of heat extraction;
   - the thickness of each of the at least two crystallization seeds is determined such as to allow the homogenization of the temperature distribution over the whole top surface area of the seeds during the heat extraction step in said furnace; this can easily be calculated approximately taking account of the heat conductivity and dimensions of each material or, more accurately, by finite element modelling (fem);
   - tile the crucible floor (1 a) with the at least two crystallization seeds of thus determined thicknesses in their corresponding positions;
   - load the crucible with a feedstock and carry out the necessary steps for melting and then crystallizing the feedstock to form an oriented crystalline semiconductor material ingot as discussed above and illustrated in Figures 1 (d) and 2(b).

A crucible according to the present invention can be manufactured easily by a person skilled in the art, as it suffices to:
- manufacture a crucible made of a silicon oxide based refractory material and comprising a floor (1 a) and side walls (1 b), in a conventional manner;
- optionally apply one or more coatings to the inner surfaces of the floor (1 a) and/or side walls (1 b) of said crucible, as known by a person skilled in the art; and
- apply to the floor (1 a) by spraying, rolling, casting, brushing, or any combination thereof, a top layer (2) of thickness, δ, of at least 500 µm, said top layer being plastically or viscously deformable at a deformation temperature below 1400 °C.

The application of a top layer (2), though novel, can easily be carried out by a person skilled in the art.

## Claims

1. Crucible (1) for the production of crystalline semiconducting material ingots, such as silicon, said crucible comprising peripheral side walls (1 b) and a floor (1 a) at least a portion of said floor being coated with a top layer (2), **characterized in that**, said top layer (2) has a thickness, δ, of at least 500 µm and **in that**, at a deformation temperature below 1400 °C said top layer is plastically or viscously deformable.

2. Crucible according to claim 1, wherein the top layer (2) comprises one or more of silicon nitride (Si₃N₄), sialon, silicon oxynitride, siloxane, silazane, fused quartz or fused silica, synthetic silica, alumina, natural or synthetic CaO-, SiO₂-, Al₂O₃-, MgO-, ZrO₂-based ceramic materials in the form of:
- a low density layer, like a foam, of density preferably comprised between 0.3 and 1.6 g/cm³, more preferably between 0.8 and 1.3 g/cm³, or
- particulate, such as non-woven fibres, hollow shells, nanoparticles, meso-spherous particles,
each of the foregoing materials preferably having an Fe content of less than 20 ppm , more preferably less than 5 ppm, most preferably less than 1 ppm.

3. Crucible according to the preceding claim, wherein the top layer comprises at least two layers of different materials, the uppermost layer being preferably made of silicon nitride (Si₃N₄).

4. Crucible according to any of the preceding claims, wherein the density of the top layer (2) is at least 20% lower than the density of the inner surfaces of the other walls defining the inner volume of the crucible.

5. Crucible according to the preceding claim, wherein the floor (1 a) joins the side walls (1 b) of the crucible forming a radius, R, and wherein the thickness, δ, of the top layer (2) is larger than the radius, R.

6. Crucible according to any of the preceding claims, wherein at least one crystallization seed (3) is impressed in the top layer (2) and preferably at least two crystallization seeds (3) are impressed in the top layer (2), with their top surfaces being substantially co-planar.

7. Crucible according to the preceding claim, wherein the at least two crystallization seeds have a different thickness and are preferably silicon seeds, more preferably monocrystalline silicon seeds.

8. Process for producing an oriented crystalline semiconductor material ingot comprising the following steps:
- providing a crucible according to any of claims 1 to 7,
- laying at least one crystallization seed (3) onto the top layer (2);
- bringing the temperature of the top layer to the deformation temperature thereof;
- applying a pressure onto the at least one crystallization seed to impress it into the top layer (2) such that it sinks at least partially into the deformable top layer ;
- filling the crucible with a load of semiconductor material feedstock;
- controlling the temperature in the crucible to melt completely the feedstock and to melt the top surface only of the at least one crystallization seed;
- extracting heat through the floor of the crucible to prevent the bottom surface of the at least one crystallization seed from melting and to initiate the oriented crystallization of the feedstock.

9. Process according to the preceding claim, wherein pressure is applied to the at least one crystallization seed by controlling the length of a rigid vertical stem from a first end thereof contacting one crystallization seed to a fixed point, such as the upper edge of the crucible, or any fixed point inside or outside the crucible.

10. Process according to claim 8 or 9, wherein the top layer (2) covers the whole area of the crucible floor (1 a), and at least two crystallization seeds are tiled side by side to cover substantially the whole area of the top layer (2), such that the top surfaces of said at least two crystallization seeds are substantially coplanar.

11. Process according to the preceding claim, wherein,
- for a given furnace, the temperature distribution over the area of the top surface of the at least two crystallization seeds is characterized during the heat extraction step;
- a mapping of hot and cold spots is established over the whole top surface area of the seeds as a function of the position of each of the at least two crystallization seeds;
- the thickness of each of the at least two crystallization seeds is determined such as to allow the homogenization of the temperature distribution over the whole top surface area of the seeds during the heat extraction step in said furnace;
- tile the crucible floor (1 a) with the at least two crystallization seeds of thus determined thicknesses in their corresponding positions;
- load the crucible with a feedstock and carry out the necessary steps for melting and crystallizing the feedstock to form an oriented crystalline semiconductor material ingot.

12. Process according to any of claims 8 to 11, wherein the one or more crystallization seeds are monocrystalline and the ingot thus crystallized is substantially monocrystalline or near monocrystalline.

13. Process according to any of claims 8 to 12, wherein the one or more crystallization seeds are silicon, preferably monocrystalline silicon, and the feedstock is composed of silicon and doping materials used in the production silicon ingots, and wherein the crystalline silicon ingot thus obtained is further treated to produce solar cells.

14. Process for manufacturing a crucible according to any of claims 1 to 7 comprising the following steps:
- manufacturing a crucible made of a silicon oxide based refractory material and comprising a floor (1 a) and side walls (1 b);
- optionally applying one or more coatings to the inner surfaces of the floor (1 a) and/or side walls (1 b) of said crucible;
- applying to the floor (1 a) by spraying, rolling, casting, brushing, or any combination thereof, a top layer (2) of thickness, δ, of at least 500 µm, said top layer being plastically or viscously deformable at a deformation temperature below 1400 °C.

## Patentansprüche

1. Schmelztiegel (1) für die Herstellung von Ingots aus einem kristallinen Halbleitermaterial, wie etwa Silicium, wobei der Schmelztiegel periphere Seitenwände (1b) sowie einen Boden (1a) umfasst, wobei zumindest ein Teil des Bodens mit einer oberen Schicht (2) beschichtet ist, **dadurch gekennzeichnet, dass** die obere Schicht (2) eine Dicke δ von zumindest 500 µm besitzt, und dass die obere Schicht bei einer Erweichungstemperatur unter 1400 °C plastisch oder viskos verformbar ist.

2. Schmelztiegel gemäß Anspruch 1, wobei die obere Schicht (2) Materialien, wie Siliciumnitrid (Si₃N₄), Sialon, Siliciumoxinitrid, Siloxan, Silazan, geschmolzenen Quarz oder geschmolzenes Siliciumdioxid, synthetisches Siliciumdioxid, Aluminiumoxid, sowie keramische Materialien, die auf natürlichem oder synthetischem CaO, SiO₂, Al₂O₃, MgO, ZrO₂ basieren, in folgender Form umfasst:
- einer Schicht mit niedriger Dichte, wie etwa eines Schaums, mit einer Dichte, die vorzugsweise zwischen 0,3 und 1,6 g/cm³ liegt, wobei zwischen 0,8 und 1,3 g/cm³ mehr bevorzugt wird, oder
- Feststoffen, wie etwa nichtgewebten Fasern, hohlen Schalen, Nano-Partikeln, Meso-Partikeln;
wobei jedes der oben genannten Materialien vorzugsweise einen Fe-Gehalt von weniger als 20 ppm, bevorzugter von weniger als 5 ppm besitzt, wobei weniger als 1 ppm am meisten bevorzugt wird.

3. Schmelztiegel gemäß dem vorhergehenden Anspruch, wobei die obere Schicht zumindest zwei Schichten von unterschiedlichen Materialien umfasst, wobei die oberste Schicht vorzugsweise aus Siliciumnitrid (Si₃N₄) besteht.

4. Schmelztiegel gemäß irgendeinem der vorhergehenden Ansprüche, wobei die Dichte der oberen Schicht (2) zumindest um 20% niedriger als die Dichte der Innenflächen der anderen Wände ist, die den Innenraum des Schmelztiegels bestimmen.

5. Schmelztiegel gemäß dem vorhergehenden Anspruch, wobei der Boden (1a) bei der Verbindung mit den Seitenwänden (1b) des Schmelztiegels einen Radius R bildet, und wobei die Dicke δ der oberen Schicht (2) größer als der Radius R ist.

6. Schmelztiegel gemäß irgendeinem der vorhergehenden Ansprüche, wobei zumindest ein Kristallisationskeim (3) in die obere Schicht (2) eingedrückt wird und vorzugsweise zumindest zwei Kristallisationskeime (3) in die obere Schicht (2) eingedrückt werden, wobei deren obere Oberflächen im Wesentlichen koplanar liegen.

7. Schmelztiegel gemäß dem vorhergehenden Anspruch, wobei die zumindest zwei Kristallisationskeime eine unterschiedliche Dicke besitzen und vorzugsweise Silicium-keime sind, wobei monokristalline Silicium-Keime mehr bevorzugt werden.

8. Verfahren zur Herstellung eines Ingots aus einem orientierten, kristallinen Halbleitermaterial, wobei das Verfahren folgende Schritte umfasst:
- Bereitstellen eines Schmelztiegels gemäß irgendeinem der Ansprüche 1 bis 7,
- Ablegen von zumindest einem Kristallisationskeim (3) auf der oberen Schicht (2);
- Bringen der Temperatur der oberen Schicht auf deren Erweichungstemperatur;
- Anlegen eines Drucks auf den zumindest einen Kristallisationskeim, um ihn in die obere Schicht (2) so einzudrücken, dass er zumindest teilweise in die verformbare obere Schicht einsinkt:
- Befüllen des Schmelztiegels mit einer Charge eines Ausgangsmaterials des Halbleiters;
- Regeln der Temperatur im Schmelztiegel, um das Ausgangsmaterial vollständig zu schmelzen und die obere Oberfläche des zumindest nur einen Kristallisationskeims zu schmelzen;
- Ableiten der Wärme durch den Boden des Schmelztiegels, um zu verhindern, dass die Bodenfläche des zumindest einen Kristallisationskeims schmilzt, und um eine orientierte Kristallisierung des Ausgangsmaterials einzuleiten.

9. Verfahren gemäß dem vorhergehenden Anspruch, wobei der Druck auf den zumindest einen Kristallisationskeim dadurch aufgebracht wird, dass die Länge eines starren, vertikalen Schafts von seinem ersten Ende, das mit einem Kristallisationskeim an einem festen Punkt in Berührung steht, bis zu einem festen Punkt geregelt wird, wie etwa der oberen Kante des Schmelztiegels oder irgendeines festen Punkts innerhalb oder außerhalb des Schmelztiegels.

10. Verfahren gemäß Anspruch 8 oder 9, wobei die obere Schicht (2) den gesamten Bereich des Bodens des Schmelztiegels (1a) bedeckt, und wobei zumindest zwei Kristallisationskeime nebeneinander ausgelegt werden, um im Wesentlichen den gesamten Bereich der oberen Schicht (2) so zu bedecken, dass die oberen Oberflächen der zumindest zwei Kristallisationskeime im Wesentlichen koplanar liegen.

11. Verfahren gemäß dem vorhergehenden Anspruch, wobei:
- für einen vorgegebenen Ofen die Temperaturverteilung über den Bereich der oberen Oberfläche der zumindest zwei Kristallisationskeime während des Wärmeableitschritts erstellt wird;
- eine Abbildung der warmen und der kalten Punkte über den gesamten Bereich der oberen Oberfläche der Keime als Funktion der Position eines jeden der zumindest zwei Kristallisationskeime erstellt wird;
- die Dicke eines jeden der zumindest zwei Kristallisationskeime so bestimmt wird, dass die Homogenisierung der Temperaturverteilung über den gesamten Bereich der oberen Oberfläche der Keime während des Wärmeableitschritts in diesem Schmelzofen ermöglicht wird;
- der Boden des Schmelztiegels (1a) mit den zumindest zwei Kristallisationskeimen, die eine auf diese Weise bestimmte Dicke besitzen, an ihren entsprechenden Positionen ausgelegt wird;
- der Schmelztiegel mit einem Ausgangsmaterial beladen wird und die notwendigen Schritte zum Schmelzen und Kristallisieren des Ausgangsmaterials ausgeführt werden, um einen Ingot aus einem orientierten, kristallinen Halbleitermaterial auszubilden.

12. Verfahren gemäß irgendeinem der Ansprüche 8 bis 11, wobei der eine Kristallisationskeim oder die mehreren Kristallisationskeime monokristallin sind, und wobei der Ingot, der auf diese Weise kristallisiert wurde, im Wesentlichen monokristallin oder nahezu-monokristallin ist.

13. Verfahren gemäß irgendeinem der Ansprüche 8 bis 12, wobei der eine Kristallisationskeim oder die mehreren Kristallisationskeime aus Silicium, vorzugsweise aus monokristallinem Silicium, bestehen und das Ausgangsmaterial aus Silizium und Dotier-Materialien zusammengesetzt ist, die bei der Herstellung von Silicium-Ingots verwendet werden, und wobei der Ingot aus kristallinem Silicium, den man auf diese Weise erhält, weiterbearbeitet wird, um Solarzellen herzustellen.

14. Verfahren zur Herstellung eines Schmelztiegels gemäß irgendeinem der Ansprüche 1 bis 7, wobei das Verfahren die folgenden Schritte umfasst:
- Herstellen eines Schmelztiegels aus einem feuerfesten Material, das auf Siliciumoxid basiert, wobei der Schmelztiegel einen Boden (1a) sowie Seitenwände (1 b) umfasst;
- Aufbringen von einer oder mehreren Beschichtungen optional auf den Innenflächen des Bodens (1a) und/oder den Seitenwänden (1 b) des Schmelztiegels;
- Aufbringen einer oberen Schicht (2), die eine Dicke δ von zumindest 500 µm beisitzt, auf dem Boden (1a) durch Aufsprühen, Rollen, Gießen, Bürsten oder irgendeiner Kombination davon, wobei die obere Schicht bei einer Erweichungstemperatur unter 1400 °C plastisch oder viskos verformbar ist.

## Revendications

1. Creuset (1) pour la production de lingots en matériau semi-conducteur cristallin, tel que le silicium, ledit creuset comprenant des parois périphériques (1b) et un fond (1a), au moins une portion dudit fond étant garnie d'une couche supérieure (2), **caractérisé en ce que** ladite couche supérieure (2) possède une épaisseur, δ, d'au moins 500 µm et **en ce que** ladite couche supérieure (2) est déformable plastiquement ou visqueusement, à une température de déformation inférieure à 1400°C.

2. Creuset suivant la revendication 1, dans lequel la couche supérieure (2) comprend un ou plusieurs des nitrure de silicium (Si₃N₄), sialon, oxynitrure de silicium, siloxane, silazane, verre de quartz ou silice vitreuse, silice synthétique, matériaux céramiques naturels or synthétiques à base de CaO, SiO₂, Al₂O₃, MgO, ZrO₂ sous forme
- d'une couche de faible densité, telle qu'une mousse, avec une densité comprise de préférence entre 0,3 et 1,6 g/cm³, plus préférablement entre 0,8 et 1,3 g/cm³ ou
- de particules, telles que des fibres non-tissées, des coquilles creuses, des nanoparticules ou des particules méso-sphériques,
chacun des matériaux précédents possédant de préférence un contenu en Fe inférieur à 20 ppm, plus préférablement, inférieur à 5 ppm et de manière encore plus préférée, inférieur à 1 ppm.

3. Creuset suivant la revendication précédente, dans lequel la couche supérieure comprend au moins deux couches de matériaux différents, la couche la plus haute étant de préférence constituée de nitrure de silicium (Si₃N₄).

4. Creuset suivant l'une quelconque des revendications précédentes, dans lequel la densité de la couche supérieure (2) est d'au moins 20% inférieure à la densité des surfaces internes des autres parois définissant le volume interne du creuset.

5. Creuset suivant la revendication précédente, dans lequel le fond (1a) relie les parois latérales (1 b) du creuset en formant un rayon de courbure, R, et dans lequel l'épaisseur, δ, de la couche supérieure (2) est plus grande que le rayon de courbure R.

6. Creuset suivant l'une quelconque des revendications précédentes, dans lequel au moins un germe de cristallisation (3) est incrusté dans la couche supérieure (2) et, de préférence, au moins deux germes de cristallisation (3) sont incrustés dans la couche supérieure (2), leur surface supérieure étant essentiellement coplanaire.

7. Creuset suivant la revendication précédente, dans lequel au moins deux germes de cristallisations ont des épaisseurs différentes et sont, de préférence, des germes de silicium, plus préférablement, des germes de silicium monocristallin.

8. Procédé de production d'un lingot en matériau semi-conducteur cristallin orienté comprenant les étapes suivantes :
- fourniture d'un creuset selon l'une quelconque des revendications 1 à 7,
- dépôt d'au moins un germe de cristallisation (3) sur la couche supérieure (2) ;
- amenée de la température de la couche supérieure à sa température de déformation ;
- application d'une pression sur ledit au moins un germe de cristallisation afin de l'incruster dans la couche supérieure (2) en sorte qu'il soit enfoncé, au moins partiellement dans la couche supérieure déformable ;
- remplissage du creuset avec une charge d'une matière de base en matériau semi-conducteur ;
- contrôle de la température dans le creuset pour fondre complètement la matière de base et pour ne fondre que la surface supérieure dudit au moins un germe de cristallisation :
- extraction de chaleur à travers le fond du creuset afin d'éviter que la surface inférieure dudit au moins un germe de cristallisation ne fonde et pour initier la cristallisation orientée de la matière de base.

9. Procédé suivant la revendication précédente, dans lequel une pression est appliquée sur ledit au moins un germe de cristallisation en contrôlant la longueur d'une tige vertical rigide entre une première extrémité en contact avec un germe de cristallisation et un point fixe, tel que le bord supérieur du creuset ou tout autre point dans ou hors du creuset.

10. Procédé suivant la revendication 8 ou 9, dans lequel la couche supérieure (2) couvre toute l'aire du fond (1a) du creuset, et au moins deux germes de cristallisation sont déposés côte à côte afin de couvrir essentiellement toute l'aire de la couche supérieure (2), en sorte que les surfaces supérieures desdits au moins deux germes de cristallisations soient essentiellement coplanaires.

11. Procédé suivant la revendication précédente dans lequel,
- on caractérise, pour un four donné, la distribution de température le long de la surface supérieure desdits au moins deux germes de cristallisation pendant l'étape d'extraction de chaleur ;
- on établit une cartographie des points chauds et froids le long de la surface supérieure des germes en fonction de la position de chacun desdits au moins deux germes de cristallisation ;
- on détermine l'épaisseur desdits au moins deux germes de cristallisation en sorte de permettre l'homogénéisation de la distribution de température froids le long de la surface supérieure des germes pendant l'étape d'extraction de chaleur dans ledit four ;
- on pave le fond (1a) du creuset avec au moins deux germes de cristallisation de l'épaisseur ainsi déterminée en leur position respective ;
- on charge le creuset avec une matière de base et met en oeuvre les étapes requises pour fondre et cristalliser la matière de base pour former un lingot de matériau semi-conducteur cristallin orienté.

12. Procédé suivant l'une quelconque des revendications 8 à 11, dans lequel un ou plusieurs germes de cristallisation sont monocristallins ou quasi monocristallins.

13. Procédé selon l'une quelconque des revendications 8 à 12, dans lequel un ou plusieurs germes de cristallisation sont en silicium, de préférence en silicium monocristallin et la matériau de base est composé de silicium et de matériaux dopants utilisés dans la production de lingots de silicium et dans lequel le lingot de silicium ainsi obtenu subit un traitement subséquent pour produire des cellules solaires.

14. Procédé pour la fabrication d'un creuset suivant l'une quelconque des revendications 1 à 7 comprenant les étapes suivantes :
- fabrication d'un creuset fait d'un matériau réfractaire à base d'oxyde de silicium et comprenant un fond (1a) et des parois latérales (1b) ;
- en option, application d'un ou plusieurs revêtements sur les surfaces internes du fond (1a) et ou les parois latérales (1 b) dudit creuset ;
- application d'une couche supérieure (2) d'une épaisseur, δ, d'au moins 500 µm, ladite couche supérieure (2) étant déformable plastiquement ou visqueusement, à une température de déformation inférieure à 1400°C sur le fond (1a) par pulvérisation, enduction au rouleau, coulage, enduction à la brosse ou toute combinaison de ceux-ci.
